# EUROPEAN PATENT APPLICATION

(11) **EP 4 492 444 A2**
(43) Date of publication of application: **15.01.2025**
(21) Application number: 24187607.7
(22) Date of filing: 10.07.2024
(51) Int. Cl.: H01L 21/822, H01L 21/8238, H01L 27/02, H01L 27/06, H01L 27/092, H01L 29/06, H01L 29/775, H01L 23/528

(54) **INTEGRATED CIRCUIT DEVICES INCLUDING STACKED FIELD-EFFECT TRANSISTORS IN MULTI-HEIGHT CELLS AND METHODS OF FORMING THE SAME**

(30) Priority: 13.07.2023 US 202363513361 P; 23.10.2023 US 202318492142
(71) Applicant: Samsung Electronics Co., Ltd., Suwon-si, Gyeonggi-do 16677 (KR)
(72) Inventor: KIM, Jintae, San Jose, CA, 95134 (US); YUN, Seungchan, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Integrated circuit devices and methods of forming the same are provided. The integrated circuit devices includes an upper transistor including an upper channel region (204, 206) on a substrate (214), a lower transistor between the substrate (214) and the upper transistor, the lower transistor including a lower channel region (202), and a power line (P2) extending longitudinally in a first horizontal direction (X). At least one of the upper channel region or the lower channel region extends longitudinally in a second horizontal direction (Y) that traverses the first horizontal direction, and the at least one of the upper channel region or the lower channel region overlaps the power line in a thickness direction (Z).

## Description

### BACKGROUND

The present disclosure generally relates to the field of integrated circuit devices and, more particularly, to integrated circuit devices including stacked field-effect transistors in multi-height cells and methods of forming the same.

As demands for high performance and/or high speed of an integrated circuit device increase, a degree of integration in the integrated circuit device also increases. Various structures of an integrated circuit device and methods of forming the same have thus been proposed to increase the integration density of the integrated circuit device. Specifically, stacked integrated circuit devices including multi-height standard cells have been researched because of their high integration density.

### SUMMARY

An integrated circuit device according to some embodiments may include an upper transistor including an upper channel region on a substrate, a lower transistor between the substrate and the upper transistor, the lower transistor including a lower channel region, and a power line extending longitudinally in a first horizontal direction. At least one of the upper channel region or the lower channel region may extend longitudinally in a second horizontal direction that traverses the first horizontal direction, and the at least one of the upper channel region or the lower channel region may overlap the power line in a thickness direction.

An integrated circuit device according to some embodiments may include a first transistor including a first channel region on a substrate, and a pair of second transistors, respectively, including a pair of second channel regions that are spaced apart from each other in a first horizontal direction. The first channel region may overlap the pair of second channel regions in a thickness direction. In some embodiments, the first channel region may be between the substrate and the pair of second channel regions. In some embodiments the pair of second channel regions may be between the substrate and the first channel region. In some embodiments the first channel region may comprise a first portion that overlaps a first one of the pair of second channel regions in the thickness direction; a second portion that overlaps a second one of the pair of second channel regions in the thickness direction; and a third portion that is between the first and second portions and is free of overlap with the pair of second channel regions in the thickness direction. In some embodiments the integrated circuit device may further comprise a power line extending longitudinally in a second horizontal direction that traverses the first horizontal direction, wherein the first channel region overlaps the power line in the thickness direction. In some embodiments the pair of second channel regions may be free of overlap with the power line in the thickness direction. In some embodiments a width of the first channel region in the first horizontal direction may be wider than a combined width of the pair of second channel regions in the first horizontal direction. In some embodiments the first channel region may be electrically connected to a first source/drain region, the pair of second channel regions may be electrically connected to second and third source/drain regions, respectively, and the first source/drain region overlaps the second and third source/drain regions in the thickness direction.

A method of forming an integrated circuit device according to some embodiments may include forming a lower transistor and an upper transistor on a substrate, the lower transistor including a lower channel region and the upper transistor including an upper channel region, and forming a power line extending longitudinally in a first horizontal direction. At least one of the upper channel region or the lower channel region may extend longitudinally in a second horizontal direction that traverses the first horizontal direction, and the at least one of the upper channel region or the lower channel region may overlap the power line in a thickness direction.

### BRIEF DESCRIPTION OF THE DRAWINGS

FIG. 1 is a schematic layout view of an integrated circuit device including multiple standard cells according to some embodiments.
FIG. 2 is an enlarged schematic layout view of a first standard cell SC1 in FIG. 1 according to some embodiments.
FIG. 3 is an enlarged schematic layout view of a first standard cell SC1 in FIG. 1 according to some embodiments.
FIGS. 3A and 3B are cross-sectional views of the first standard cell SC1 taken along the lines Y1-Y1' and Y2-Y2' in FIG. 3, respectively, according to some embodiments.
FIG. 4 is an enlarged schematic layout view of a first standard cell SC1 in FIG. 1 according to some embodiments.
FIGS. 4A and 4B are cross-sectional views of the first standard cell SC1 taken along the lines Y1-Y1' and Y2-Y2' in FIG. 4, respectively, according to some embodiments.
FIG. 5 is an enlarged schematic layout view of a first standard cell SC1 in FIG. 1 according to some embodiments.
FIGS. 5A and 5B are cross-sectional views of the first standard cell SC1 taken along the lines Y1-Y1' and Y2-Y2' in FIG. 5, respectively, according to some embodiments.
FIG. 6 is an enlarged schematic layout view of a first standard cell SC1 in FIG. 1 according to some embodiments.
FIG. 6A is a cross-sectional view of the first standard cell SC1 taken along the line Y2-Y2' in FIG. 6 according to some embodiments.
FIG. 7 is a circuit diagram of an example logic circuit included in a first standard cell SC1 in FIG. 1 according to some embodiments.
FIG. 8 is a flow chart of methods of forming an integrated circuit device according to some embodiments.
FIGS. 9 through 12 are cross-sectional views illustrating methods of forming an integrated circuit device according to some embodiments.

### DETAILED DESCRIPTION

An integrated circuit device may include multiple standard cells. Stacked field-effect transistors (FETs) may be included in the standard cells to form logic circuits therein. The stacked FETs may reduce a standard cell's area by about half compared to that of a standard cell including non-stacked FETs, thereby facilitating a higher degree of integration in the integrated circuit device. To improve performance of the integrated circuit device, one or more of the standard cells may be a multi-height (y axis) standard cell. However, channel regions in the multi-height standard cell may be spaced apart from power lines thereof that define cell boundaries. The channel regions in the multi-height standard cell may thus not overlap a power line, which can restrict an effective channel width, increase contact complexity, and impede the performance of the integrated circuit device. According to some embodiments of the present disclosure, an integrated circuit device may include a stacked FET in a multi-height standard cell having a lower channel region and/or an upper channel region that is merged such that it overlaps a power line, thereby increasing an effective channel width, reducing contact complexity in the multi-height standard cell, and improving the performance of the integrated circuit device.

Example embodiments will be described in greater detail with reference to the attached figures.

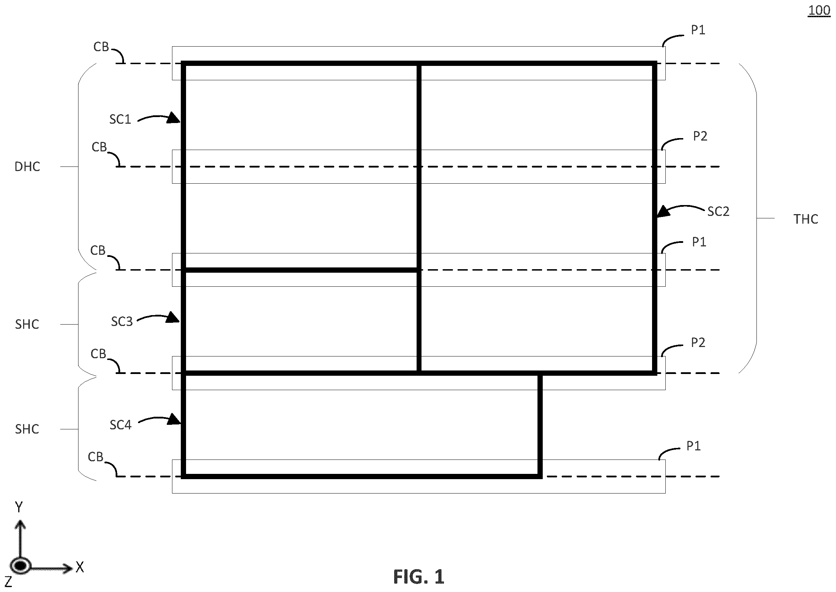

FIG. 1 is a schematic layout view of an integrated circuit device including multiple standard cells according to some embodiments. For ease of illustration, FIG. 1 only illustrates power lines (e.g., first and second power lines P1 and P2). The dotted lines in FIG. 1 represent cell boundaries CB, and the solid black lines delineate standard cells (e.g., first to fourth standard cells SC1, SC2, SC3, and SC4). Referring to FIG. 1, an integrated circuit device 100 may include first to fourth standard cells SC1, SC2, SC3, and SC4. The number of standard cells in FIG. 1 is merely an example, and the integrated circuit device 100 may include more or less than four standard cells. The integrated circuit device 100 may also include multiple first power lines P1 and multiple second power lines P2. The first power lines P1 may be electrically connected to a first power source having a first voltage (e.g., a drain voltage V_{DD}). The second power lines P2 may be electrically connected to a second power source having a second voltage (e.g., a source voltage Vss). For example, the second voltage may be an electrical ground voltage. The first and second power lines P1 and P2 may be provided to supply power to the first to fourth standard cells SC 1, SC2, SC3, and SC4. The first and second power lines P1 and P2 may supply different potentials to the first to fourth standard cells SC1, SC2, SC3, and SC4.

Each of the first to fourth standard cells SC1, SC2, SC3, and SC4 may constitute a small circuit or circuit components used to build up logic or memory functionality, for example, an inverter, a 2-input NAND gate, a 3-input NAND gate, a 2-input NOR, a 3-input NOR, an And-Or inverter (AOI), an Or-And inverter (OAI), an XNOR gate, an XOR gate, a multiplexer (MUX), a latch, a D-flip-flop, or the like.

The first and second power lines P1 and P2 may extend longitudinally in a first direction X (also referred to as a first horizontal direction). As used herein "an element A extends longitudinally in a first direction X" (or similar language) means that a longest dimension of the element A extends in the first direction X. The first and second power lines P1 and P2 may be alternately arranged in a second direction Y (also referred to as a second horizontal direction, or cell "height"). The first and second power lines P1 and P2 may be spaced apart from each other in the second direction Y. The first direction X may traverse the second direction Y. In some embodiments, the first direction X may be perpendicular to the second direction Y.

Cell boundaries CB in the integrated circuit device 100 may be defined by the first and second power lines P1 and P2 (and hence, their length in the first direction X). For example, each cell boundary CB may correspond to a center portion of one of the first power lines P1 or the second power lines P2 in the second direction Y. Each of the cell boundaries CB may be an imaginary line that extends in the first direction X and intersects the center portion of one of the first power lines P1 or the second power lines P2 in the second direction Y. Each of the cell boundaries CB may also be an imaginary plane defined by the first direction X and a third direction Z (also referred to as a thickness direction). The third direction Z may be perpendicular to the first direction X and the second direction Y. Although the cell boundary CB defined by the second power line P2 is illustrated in the first and second standard cells SC1 and SC2, that cell boundary CB is not a cell boundary of the first and second standard cells SC1 and SC2. Rather, that cell boundary CB is a cell boundary of adjacent standard cells (e.g., a single height cell).

The cell boundaries CB may define a cell height of each of the first to fourth standard cells SC1, SC2, SC3, and SC4. As used herein, a "cell height" refers to a height of a standard cell in the second direction Y in a plan view (i.e., a layout view). For example, a single height standard cell SHC may be defined by a pair of cell boundaries CB with no power lines therebetween-that is, the cell extends from a power line P1 to an immediately adjacent power line P2. A double height standard cell DHC may be defined by a pair of cell boundaries CB with one power line therebetween. For example, such a cell would extend from a power line P1 (or P2), and extend to one of the next power line of the same type P1 (or P2, respectively), and include a power line of the opposite type. A triple height standard cell THC may be defined by a pair of cell boundaries CB with two power lines therebetween. For example, such a cell would extend from a power line P1 to one of the second most adjacent power line P2, and hence also include closer power lines P1 and P2. Although not illustrated in FIG. 1, a quadruple (and more) height standard cell may be defined by a pair of cell boundaries CB with three (or more) power lines therebetween. Double, triple, quadruple, etc. height standard cells may also be referred to as multi-height standard cells.

A height of each standard cell in the second direction Y may be at a fixed interval defined by the cell boundaries CB, and/or the distance between power lines P1 and P2. (e.g., a single, double, triple, or quadruple height standard cell). A height of a double height standard cell (DHC) in the second direction Y may be two times greater than a height of a single height standard cell (SHC) in the second direction Y. Similarly, a height of a triple height standard cell (THC) in the second direction Y may be three times greater than a height of a single height standard cell (SHC) in the second direction Y, and a height of a quadruple height standard cell in the second direction Y may be four times greater than a height of a single height standard cell (SHC) in the second direction Y.

Some of the standard cells in the integrated circuit device 100 may be single height standard cells SHC, and each of the single height standard cells SHC may include a single first power line P1 and a single second power line P2 extending on its cell boundaries CB, respectively. For example, the third and fourth standard cells SC3 and SC4 in FIG. 1 are single height standard cells SHC.

Some of the standard cells in the integrated circuit device 100 may be double height standard cells DHC, and each of the double height standard cells DHC may include a pair of first power lines P1 or a pair of second power lines P2 extending on its cell boundaries CB, respectively, and an opposite power line P2 or P1, respectively, therebetween. For example, the first standard cell SC1 in FIG. 1 is a double height standard cell DHC.

Some of the standard cells in the integrated circuit device 100 may be triple height standard cells THC, and each of the triple height standard cells THC may include a single first power line P1 and a single second power line P2 extending on its cell boundaries CB, respectively, and a first power line P1 and a second power line P2 therebetween. For example, the second standard cell SC2 in FIG. 1 is a triple height standard cell THC.

Although not illustrated in FIG. 1, some of the standard cells in the integrated circuit device 100 may be quadruple height standard cells, and each of the quadruple height standard cells may include a pair of first power lines P1 or a pair of second power lines P2 extending on its cell boundaries CB, respectively.

The first to fourth standard cells SC1, SC2, SC3, and SC4 may be arranged in the first direction X and the second direction Y. A cell height of the second standard cell SC2 may be substantially equal to a combined cell height of the first standard cell SC1 and the third standard cell SC3. In some embodiments, the standard cells may have different widths in the first direction X. For example, the fourth standard cell SC4 may have a different width in the first direction X than the first to third standard cells SC1, SC2, and SC3. A width of each standard cell in the first direction X may not necessarily be at a fixed interval. In some embodiments, a height in the second direction Y and/or a width in the first direction X of each of the first to fourth standard cells SC1, SC2, SC3, and SC4 may be determined according to the design of logic circuit(s) therein.

Among the first and second power lines P1 and P2, a power line located at a cell boundary CB between standard cells in the second direction Y may be a shared power line. For example, the first power line P1 located at the cell boundary CB between the first standard cell SC1 and the third standard cell SC3 may be a shared power line. Similarly, the second power line P2 located at the cell boundary CB between the third standard cell SC3 and the fourth standard cell SC4 may be a shared power line.

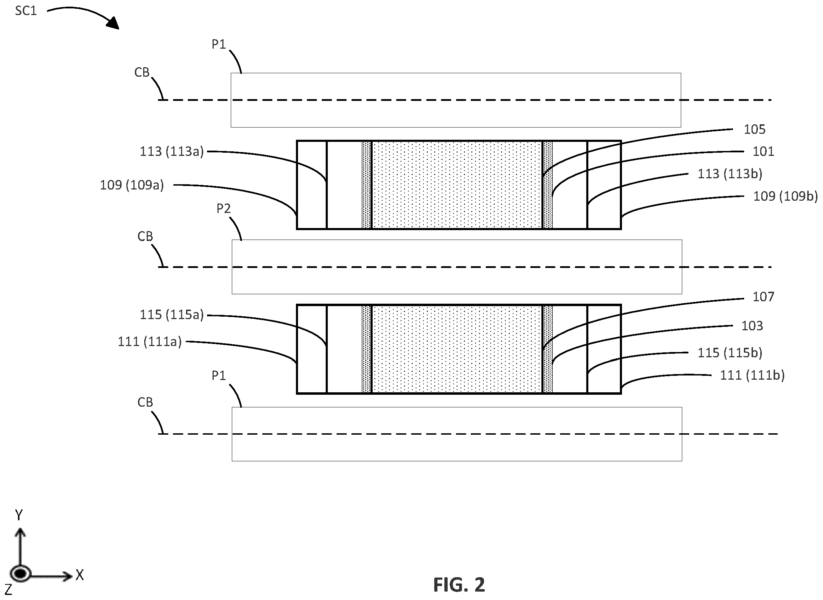

FIG. 2 is an enlarged schematic layout view of a first standard cell SC1 in FIG. 1 according to some embodiments.

Referring to FIG. 2, the first standard cell SC1 may include first and second lower channel regions 101 and 103 (also referred to as a pair of lower channel regions) and first and second upper channel region 105 and 107 (also referred to as a pair of upper channel regions). The first and second upper channel regions 105 and 107 may be on the first and second lower channel regions 101 and 103, respectively. The first lower channel region 101 may be electrically connected to a first pair of lower source/drain regions 109 (e.g., a first lower source/drain region 109a and a second lower source/drain region 109b) on opposing sides thereof in the first direction X, respectively. Similarly, the second lower channel region 103 may be electrically connected to a second pair of lower source/drain regions 111 (e.g., a third lower source/drain region 111a and a fourth lower source/drain region 111b) on opposing sides thereof in the first direction X, respectively. The first upper channel region 105 may be electrically connected to a first pair of upper source/drain regions 113 (e.g., a first upper source/drain region 113a and a second upper source/drain region 113b) on opposing sides thereof in the first direction X, respectively. Similarly, the second upper channel region 107 may be electrically connected to a second pair of upper source/drain regions 115 (e.g., a third upper source/drain region 115a and a fourth upper source/drain region 115b) on opposing sides thereof in the first direction X, respectively.

The first and second lower channel regions 101 and 103, the first and second upper channel regions 105 and 107, the first and second pairs of lower source/drain regions 109 and 111, and the first and second pairs of upper source/drain regions 113 and 115 may be included in one or more stacked FETs. Each of the first and second lower channel regions 101 and 103 and the first and second upper channel regions 105 and 107 may be spaced apart in the second direction Y from the second power line P2, which is between the pair of first power lines P1 (and cell boundaries CB thereof) defining a cell height of the first standard cell SC1 (e.g., a double height cell). The first and second lower channel regions 101 and 103 and the first and second upper channel regions 105 and 107 may thus not overlap the second power line P2 in the third direction Z, which can restrict an effective channel width and impede the performance of the integrated circuit device 100.

For example, the first and second lower channel regions 101 and 103 may be separated (e.g., may not be merged or formed as a single unit) so that they are spaced apart from the second power line P2 in the second direction Y on opposing sides thereof, respectively. Similarly, the first and second upper channel regions 105 and 107 may be separated (e.g., may not be merged or formed as a single unit) so that they are spaced apart from the second power line P2 in the second direction Y on opposing sides thereof, respectively. Each of the first and second pairs of lower source/drain regions 109 and 111 and the first and second pairs of upper source/drain regions 113 and 115 may also not overlap the second power line P2 in the third direction Z. In other words, each of the first and second lower channel regions 101 and 103, the first and second upper channel regions 105 and 107, the first and second pairs of lower source/drain regions 109 and 111, and the first and second pairs of upper source/drain regions 113 and 115 may be free of overlap with the second power line P2 in the third direction Z.

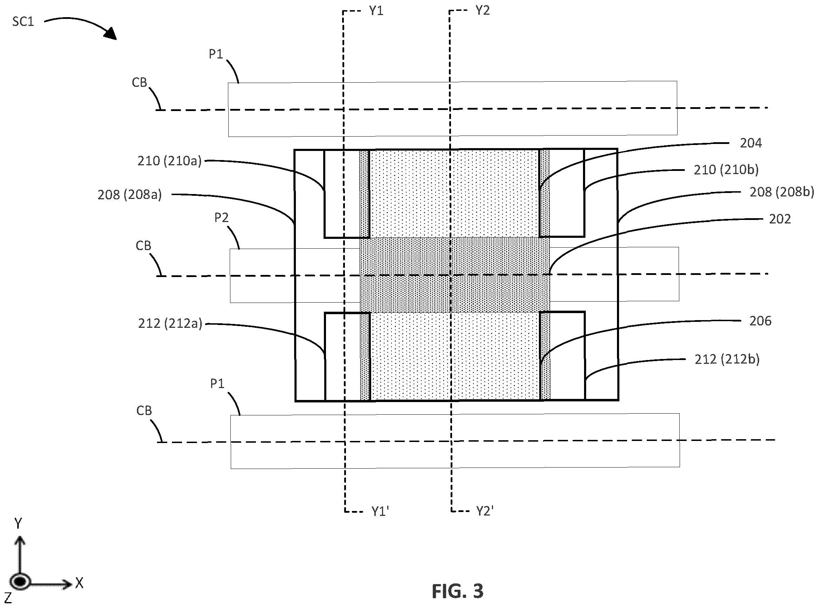

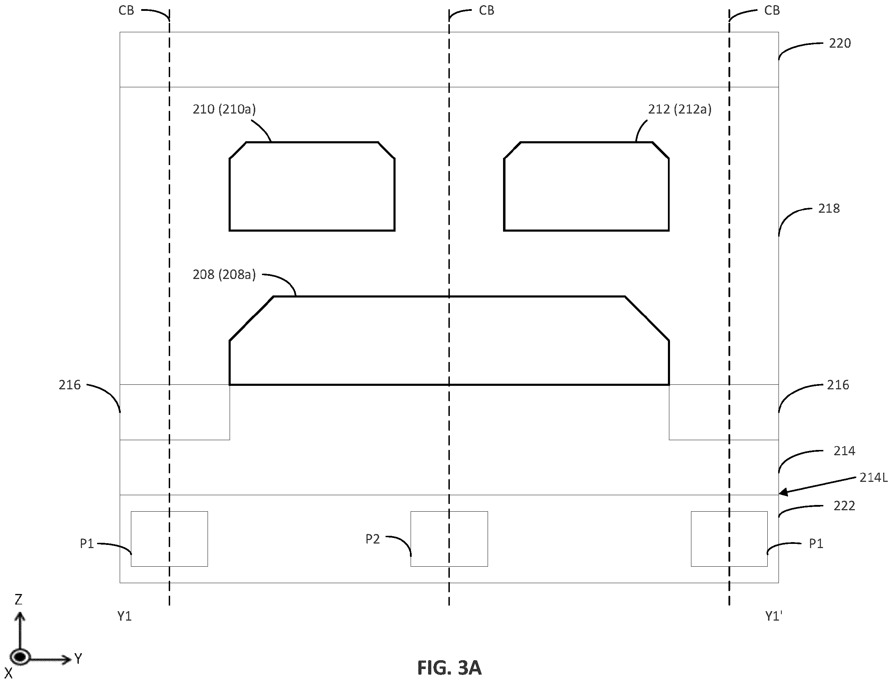

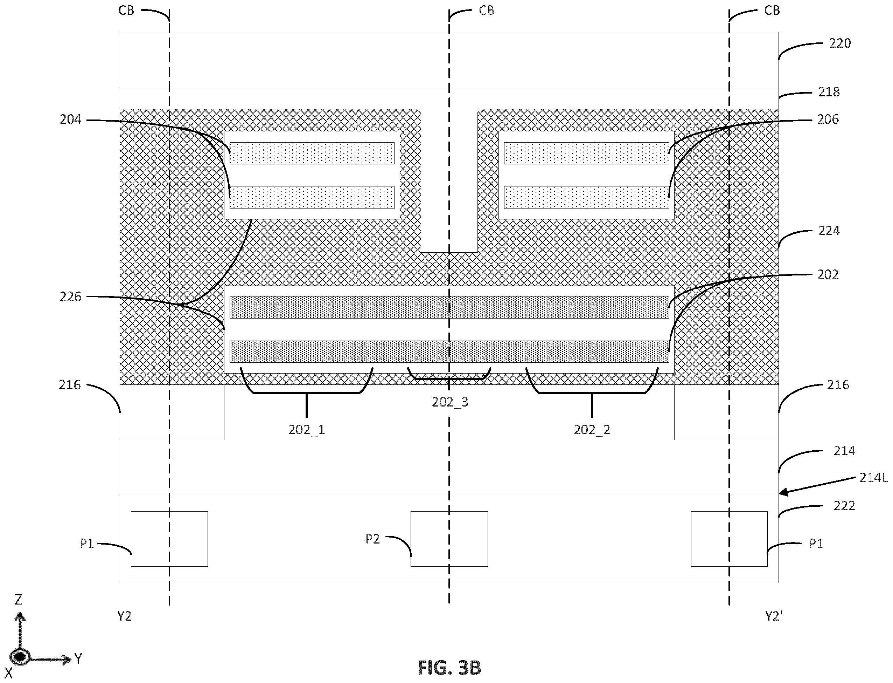

FIG. 3 is an enlarged schematic layout view of a first standard cell SC1 in FIG. 1 according to some embodiments. FIGS. 3A and 3B are cross-sectional views of the first standard cell SC1 taken along the lines Y1-Y1' and Y2-Y2' in FIG. 3, respectively, according to some embodiments. For ease of illustration, FIG. 3 only illustrates some elements included in the first standard cell SC1.

Referring to FIGS. 3, 3A, and 3B, the first standard cell SC1 may include a substrate 214. A lower surface 214L of the substrate 214 may extend in the first direction X and the second direction Y. The first direction X and the second direction Y may be parallel to the lower surface 214L of the substrate 214.

The substrate 214 may include semiconductor material(s) (e.g., Si, Ge, SiGe, GaP, GaAs, SiC, SiGeC and/or InP) and/or may include insulating material(s) (e.g., silicon oxide, silicon oxynitride, silicon nitride, silicon carbonitride, and/or a low-k material). In some embodiments, the substrate 214 may be a bulk substrate (e.g., a silicon wafer), a semiconductor on insulator (SOI) substrate, or an insulating layer (e.g., a monolithic insulating layer). A thickness of the substrate 214 in the third direction Z may be in a range of 50 nanometers (nm) to 100 nm. For example, the low-k material may include fluorine-doped silicon oxide, organosilicate glass, carbon-doped oxide, porous silicon dioxide, porous organosilicate glass, spin-on organic polymeric dielectrics and/or spin-on silicon based polymeric dielectric.

The substrate 214 may include portions separated from each other by a trench isolation layer 216. The trench isolation layer 216 may include an insulating material(s) (e.g., silicon oxide, silicon oxynitride, silicon nitride, silicon carbonitride, silicon boron nitride and/or a low-k material). A lower channel region 202 and first and second upper channel regions 204 and 206 (also referred to as a pair of upper channel regions) may be on a portion of the substrate 214 that is between the trench isolation layers 216.

In some embodiments, each of the lower channel region 202 and the first and second upper channel regions 204 and 206 may include multiple channel regions stacked in the third direction Z, and the channel regions may be spaced apart from each other in the third direction Z. Although FIG. 3B illustrates that each of the lower channel region 202 and the first and second upper channel regions 204 and 206 includes two channel regions stacked in the third direction Z, the present disclosure is not limited thereto. In some embodiments, each of the lower channel region 202 and the first and second upper channel regions 204 and 206 may include more or less than two channel regions stacked in the third direction Z.

The first standard cell SC1 may include a gate electrode 224. Although not illustrated, the first standard cell SC1 may also include a gate insulator. The gate insulator may be provided between the gate electrode 224 and each of the lower channel region 202 and the first and second upper channel regions 204 and 206 to provide insulation therebetween. The gate electrode 224 and the gate insulator together may constitute a gate structure. While FIG. 3B illustrates that the gate electrode 224 is a common gate layer, in some embodiments, a lower portion of the gate electrode 224 may be separated from and spaced apart from an upper portion of the gate electrode 224 (e.g., by insulating layer(s)). The lower channel region 202 and the first and second upper channel regions 204 and 206 may extend through the gate electrode 224 in the first direction X, and the gate insulator may be provided between the gate electrode 224 and each of the lower channel region 202 and the first and second upper channel regions 204 and 206 to provide insulation therebetween. The gate insulator may contact the gate electrode 224 and/or each of the lower channel region 202 and the first and second upper channel regions 204 and 206. The gate insulator may separate the gate electrode 224 from the lower channel region 202 and the first and second upper channel regions 204 and 206. Although not illustrated in FIG. 3, the gate electrode 224 may extend longitudinally in the second direction Y to intersect the lower channel region 202 and the first and second upper channel regions 204 and 206.

The first standard cell SC1 may also include a pair of lower source/drain regions 208 (e.g., first and second lower source/drain regions 208a and 208b), a first pair of upper source/drain regions 210 (e.g., first and second upper source/drain regions 210a and 210b), and a second pair of upper source/drain regions 212 (e.g., third and fourth upper source/drain regions 212a and 212b). Although not illustrated in FIG. 3, the gate electrode 224 may be provided between the pair of lower source/drain regions 208 in the first direction X, between the first pair of upper source/drain regions 210 in the first direction X, and between the second pair of upper source/drain regions 212 in the first direction X. The pair of lower source/drain regions 208 may contact opposing side surfaces of the lower channel region 202 in the first direction X, respectively, as illustrated in FIG. 3. Similarly, the first pair of upper source/drain regions 210 may contact opposing side surfaces of the first upper channel region 204 in the first direction X, respectively, and the second pair of upper source/drain regions 212 may contact opposing side surfaces of the second upper channel region 206 in the first direction X, respectively.

Each of the lower channel region 202 and the first and second upper channel regions 204 and 206 may include semiconductor material(s) (e.g., Si, Ge, SiGe, GaP, GaAs, SiC, SiGeC and/or InP). In some embodiments, each of the lower channel region 202 and the first and second upper channel regions 204 and 206 may be a nanosheet that may have a thickness in a range of 1 nm to 100 nm in the third direction Z or may be a nanowire that may have a circular cross-section with a diameter in a range of 1 nm to 100 nm.

Although not illustrated, in some embodiments, one or more of the lower channel region 202 and the first and second upper channel regions 204 and 206 may be shaped like a fin. When the lower channel region 202, the first upper channel region 204, and/or the second upper channel region 206 are nanosheets or nanowires, the gate electrode 224 may surround the lower channel region 202, the first upper channel region 204, and/or the second upper channel region 206 on four sides thereof. When the lower channel region 202, the first upper channel region 204, and/or the second upper channel region 206 have a fin shape, the gate electrode 224 may surround the lower channel region 202, the first upper channel region 204, and/or the second upper channel region 206 on two, three, or four sides thereof.

Each of the pair of lower source/drain regions 208, the first pair of upper source/drain regions 210, and the second pair of upper source/drain regions 212 may include a semiconductor layer (e.g., a silicon (Si) layer and/or a silicon germanium (SiGe) layer) and may additionally include dopants in the semiconductor layer. In some embodiments, each of the pair of lower source/drain regions 208, the first pair of upper source/drain regions 210, and the second pair of upper source/drain regions 212 may include a metallic layer that includes, for example, tungsten (W), aluminum (Al), copper (Cu), molybdenum (Mo), cobalt (Co) and/or ruthenium (Ru).

The gate insulator may include a single layer or multiple layers (e.g., an interfacial layer and/or a high-k material layer). For example, the interfacial layer may include a silicon oxide layer, and the high-k material layer may include Al₂O₃, HfO₂, ZrO₂, HfZrO₄, TiO₂, Sc₂O₃, Y₂O₃, La₂O₃, Lu₂O₃, Nb₂O₅ and/or Ta₂O₅.

The gate electrode 224 may include a single layer or multiple layers. In some embodiments, the gate electrode 224 may include a metallic layer that includes, for example, W, Al, Cu, Mo, Co, and/or Ru.

In some embodiments, a work function layer(s) 226 may be provided between the gate electrode 224 and the gate insulator. In some embodiments, the work function layer(s) 226 may separate the gate electrode 224 from the gate insulator. The work function layer(s) 226 may include, for example, a TiN layer, a TaN layer, a TiAl layer, a TiC layer, a TiAlC layer, a TiAlN layer and/or a WN layer.

A lower transistor may include the lower channel region 202, the pair of lower source/drain regions 208, and a portion of the gate electrode 224. A first upper transistor may include the first upper channel region 204, the first pair of upper source/drain regions 210, and a portion of the gate electrode 224. A second upper transistor may include the second upper channel region 206, the second pair of upper source/drain regions 212, and a portion of the gate electrode 224.

In some embodiments, the lower transistor may be a P-type metal-oxide semiconductor FET (PMOSFET), and the first and second upper transistors may be N-type MOSFETs (NMOSFETs), or vice versa, depending on the specifications of the first standard cell SC1. Together, the lower transistor and the first and second upper transistors may constitute a stacked FET.

In some embodiments, the gate electrode 224 may be a common gate layer, as illustrated in FIG. 3B. A first portion of the gate electrode 224 may be a first gate electrode of the first upper transistor including the first upper channel region 204, a second portion of the gate electrode 224 may be a second gate electrode of the second upper transistor including the second upper channel region 206, and a third portion of the gate electrode 224 may be a third gate electrode of the lower transistor including the lower channel region 202. As the gate electrode 224 is shared by the lower transistor and the first and second upper transistors, an input of the first standard cell SC1 may be applied in common through the gate electrode 224. Although FIG. 3B illustrates that the gate electrode 224 is shared by the lower transistor and the first and second upper transistors, the present disclosure is not limited thereto. In some embodiments, a lower portion of the gate electrode 224 may be separated from and spaced apart from an upper portion of the gate electrode 224. For example, insulating layer(s) may be between the lower and upper portions of the gate electrode 224 and may separate the lower portion of the gate electrode 224 from the upper portion of the gate electrode 224. In this case, the lower portion of the gate electrode 224 may be a first gate electrode of the lower transistor, and the upper portion of the gate electrode 224 may be a second gate electrode of the first and second upper transistors.

In some embodiments, each of the lower transistor and the first and second upper transistors may be a three-dimensional (3D) FET such as a multi-bridge channel FET (MBCFET). In some embodiments, one or more of the lower transistor and the first and second upper transistors may have a structure different from that illustrated. For example, one or more of the lower transistor and the first and second upper transistors may be a gate-all-around FET (GAAFET) including a single channel region or a fin-shaped FET (FinFET).

An interlayer insulating layer 218 may be provided on the substrate 214, and the lower transistor and the first and second upper transistors may be provided in the interlayer insulating layer 218. In particular, the lower channel region 202, the first and second upper channel regions 204 and 206, the pair of lower source/drain regions 208, the first pair of upper source/drain regions 210, the second pair of upper source/drain regions 212, and the gate electrode 224 may be provided in the interlayer insulating layer 218.

Although the interlayer insulating layer 218 is illustrated as a single layer, in some embodiments, the interlayer insulating layer 218 may include multiple layers. A lower surface of the interlayer insulating layer 218 may contact an upper surface of the trench isolation layer 216. The interlayer insulating layer 218 may extend between the first upper channel region 204 and the second upper channel region 206. The interlayer insulating layer 218 may separate the first upper channel region 204 from the second upper channel region 206 in the second direction Y. For example, the interlayer insulating layer 218 may include insulating material(s) (e.g., silicon oxide, silicon oxynitride, silicon nitride, silicon carbonitride, silicon boron nitride and/or a low-k material). As used herein, "a lower surface" of an element may refer to a surface facing the substrate 214, and "an upper surface" refers to a surface opposite the lower surface thereof. Further, as used herein, "a lower portion" refers to a portion that is closer than "an upper portion" to the substrate 214 and is thus between the upper portion thereof and the substrate 214.

The first standard cell SC1 may include a back-end-of-line (BEOL) structure 220 that is formed through the BEOL portion of device fabrication. The BEOL structure 220 may include a BEOL insulating layer, conductive wires (e.g., metal wires) that are provided in the BEOL insulating layer and are stacked in the third direction Z, and conductive via plugs (e.g., metal via plugs), each of which may electrically connect two conductive wires that are spaced apart from each other in the third direction Z. The BEOL insulating layer may include, for example, silicon oxide, silicon oxynitride, silicon nitride, silicon carbonitride, silicon boron nitride and/or a low-k material.

The first standard cell SC1 may also include a backside power distribution network structure (BSPDNS) 222. The BSPDNS 222 may contact the lower surface 214L of the substrate 214. The BSPDNS 222 may include a backside insulator, and the first and second power lines P1 and P2 may be provided in the backside insulator. The BSPDNS 222 may include a power delivery network including the first and second power lines P1 and P2. The first and second power lines P1 and P2 may each be electrically connected to a power source with a predetermined voltage (e.g., a drain voltage V_{DD} or a source voltage Vss), which is used to power the pair of lower source/drain regions 208, the first pair of upper source/drain regions 210, and/or the second pair of upper source/drain regions 212. For example, the first and second power lines P1 and P2 may be electrically connected to the pair of lower source/drain regions 208, the first pair of upper source/drain regions 210, and/or the second pair of upper source/drain regions 212 through conductive via(s) and/or contact structure(s).

The BSPDNS 222 may include one or more conductive layers (e.g., metal layers) stacked in the third direction Z that provide power delivery. The conductive layers may be respectively included in insulating layers, and conductive via plugs (e.g., metal via plugs) may electrically connect the conductive layers to each other in the third direction Z. For example, the backside insulator of the BSPDNS 222 may include multiple layers stacked on the lower surface 214L of the substrate 214. The conductive layers may include one or more conductive wires (e.g., metal wires). In some embodiments, an intervening structure may be provided between the substrate 214 and the BSPDNS 222 and may separate the substrate 214 from the BSPDNS 222. The BSPDNS 222 may increase a power delivery efficiency in the first standard cell SC1, reduce an area used for power delivery in the first standard cell SC1, and/or improve a voltage drop (i.e., IR drop) in the first standard cell SC1.

The lower channel region 202 may be formed such that it extends longitudinally in the second direction Y and overlaps the second power line P2 in the third direction Z. In other words, the second power line P2 and the cell boundary CB defined by the second power line P2 may overlap the lower channel region 202 in the third direction Z. For example, the lower channel region 202 may include a central portion in the second direction Y (e.g., a third portion 202_3) that overlaps the second power line P2 in the third direction Z. As used herein, "an element A overlaps an element B in a third direction Z" (or similar language) means that there is at least one line that extends in the third direction Z and intersects both the elements A and B.

The lower channel region 202 may be electrically connected to the pair of lower source/drain regions 208 on opposing sides thereof in the first direction X, respectively. The pair of lower source/drain regions 208 may extend longitudinally in the second direction Y and overlap the second power line P2 in the third direction Z. For example, each of the pair of lower source/drain regions 208 may include a central portion in the second direction Y that overlaps the second power line P2 in the third direction Z.

The first and second upper channel regions 204 and 206 may be on the lower channel region 202. The lower channel region 202 may be between the substrate 214 and the first and second upper channel regions 204 and 206. The first and second upper channel regions 204 and 206 may not be merged or formed as a single unit, and may not overlap the second power line P2 in the third direction Z. That is, the first and second upper channel regions 204 and 206 may be free of overlap with the second power line P2 and the cell boundary CB defined by the second power line P2 in the third direction Z.

The first upper channel region 204 may be electrically connected to the first pair of upper source/drain regions 210 on opposing sides thereof in the first direction X, respectively. The second upper channel region 206 may be electrically connected to the second pair of upper source/drain regions 212 on opposing sides thereof in the first direction X, respectively. The first pair of upper source/drain regions 210 and the second pair of upper source/drain regions 212 may be free of overlap with the second power line P2 and the cell boundary CB defined by the second power line P2 in the third direction Z.

A width of the lower channel region 202 in the second direction Y may be greater than a width of the first upper channel region 204 in the second direction Y. Similarly, the width of the lower channel region 202 in the second direction Y may be greater than a width of the second upper channel region 206 in the second direction Y. For example, the width of the lower channel region 202 in the second direction Y may be at least 1.5 times greater (i.e., at least 1.5 times wider) than the width of each of the first and second upper channel regions 204 and 206 in the second direction Y. In some embodiments, the width of the lower channel region 202 in the second direction Y may be at least 2 times greater (i.e., at least 2 times wider) than the width of each of the first and second upper channel regions 204 and 206 in the second direction Y. In some embodiments, the width of the lower channel region 202 in the second direction Y may be greater than a combined width of the first and second upper channel regions 204 and 206 in the second direction Y.

Respective widths of the pair of lower source/drain regions 208 in the second direction Y may be greater than respective widths of the first pair of upper source/drain regions 210 in the second direction Y. Similarly, the respective widths of the pair of lower source/drain regions 208 in the second direction Y may be greater than respective widths of the second pair of upper source/drain regions 212 in the second direction Y. For example, the respective widths of the pair of lower source/drain regions 208 in the second direction Y may be at least 1.5 times greater (i.e., at least 1.5 times wider) than the respective widths of the first pair of upper source/drain regions 210 in the second direction Y. Similarly, the respective widths of the pair of lower source/drain regions 208 in the second direction Y may be at least 1.5 times greater (i.e., at least 1.5 times wider) than the respective widths of the second pair of upper source/drain regions 212 in the second direction Y. In some embodiments, the respective widths of the pair of lower source/drain regions 208 in the second direction Y may be at least 2 times greater (i.e., at least 2 times wider) than the respective widths of the first pair of upper source/drain regions 210 in the second direction Y. Similarly, the respective widths of the pair of lower source/drain regions 208 in the second direction Y may be at least 2 times greater (i.e., at least 2 times wider) than the respective widths of the second pair of upper source/drain regions 212 in the second direction Y.

In some embodiments, the width of the first lower source/drain region 208a in the second direction Y may be greater than a combined width of the first and third upper source/drain regions 210a and 212a in the second direction Y and may also be greater than a combined width of the second and fourth upper source/drain regions 210b and 212b in the second direction Y. Similarly, the width of the second lower source/drain region 208b in the second direction Y may be greater than the combined width of the first and third upper source/drain regions 210a and 212a in the second direction Y and may also be greater than the combined width of the second and fourth upper source/drain regions 210b and 212b in the second direction Y.

The lower channel region 202 may overlap the first and second upper channel regions 204 and 206 in the third direction Z. The first lower source/drain region 208a may overlap the first and third upper source/drain regions 210a and 212a in the third direction Z. The second lower source/drain region 208b may overlap the second and fourth upper source/drain regions 210b and 212b in the third direction Z.

The lower channel region 202 may include a first portion 202_1, a second portion 202_2, and a third portion 202_3 (see FIG. 3B). The first and second portions 202_1 and 202_2 of the lower channel region 202 may be free of overlap with the second power line P2 in the third direction Z. The third portion 202_3 of the lower channel region 202 may be between the first and second portions 202_1 and 202_2 and may overlap the second power line P2 in the third direction Z. For example, the first portion 202_1 of the lower channel region 202 may be between the first upper channel region 204 and the substrate 214, and the second portion 202_2 of the lower channel region 202 may be between the second upper channel region 206 and the substrate 214. The third portion 202_3 of the lower channel region 202 may be a central portion of the lower channel region 202 in the second direction Y. The first portion 202_1 of the lower channel region 202 may overlap the first upper channel region 204 in the third direction Z, and the second portion 202_2 of the lower channel region 202 may overlap the second upper channel region 206 in the third direction Z. The third portion 202_3 of the lower channel region 202 may be free of overlap with the first and second upper channel regions 204 and 206 in the third direction Z.

The second power line P2 may be spaced apart from the first power lines P1 in the second direction Y. The first standard cell SC1 is a double height cell and thus the lower channel region 202 and the first and second upper channel regions 204 and 206 may be free of overlap with the first power lines P1 in the third direction Z. The lower channel region 202 may include a central portion in the second direction Y (e.g., the third portion 202_3) that is spaced apart from each of the first power lines P1 in the second direction Y by an equal distance. The first upper channel region 204 may include a central portion in the second direction Y that is spaced apart from one of the first power lines P1 and the second power line P2 in the second direction Y by an equal distance. The second upper channel region 206 may include a central portion in the second direction Y that is spaced apart from the other one of the first power lines P1 and the second power line P2 in the second direction Y by an equal distance.

The lower transistor of the stacked FET may include the lower channel region 202 that is merged, or singular, such that it extends longitudinally in the second direction Y and overlaps the second power line P2 in the third direction Z. Accordingly, an effective channel width of the lower transistor in the second direction Y may be increased, thereby improving the performance of the integrated circuit device. Further, the first standard cell SC1 may have improved timing synchronization because of the increased effective channel width of the lower transistor.

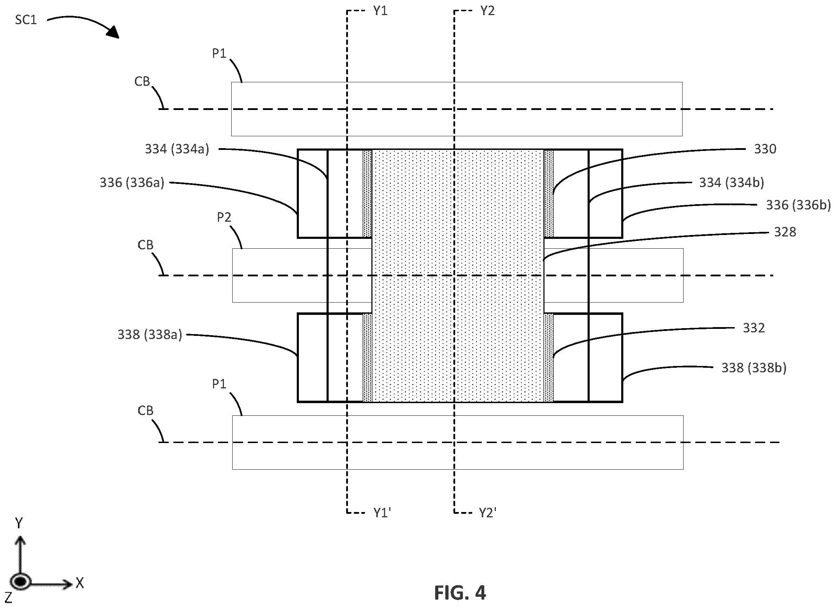

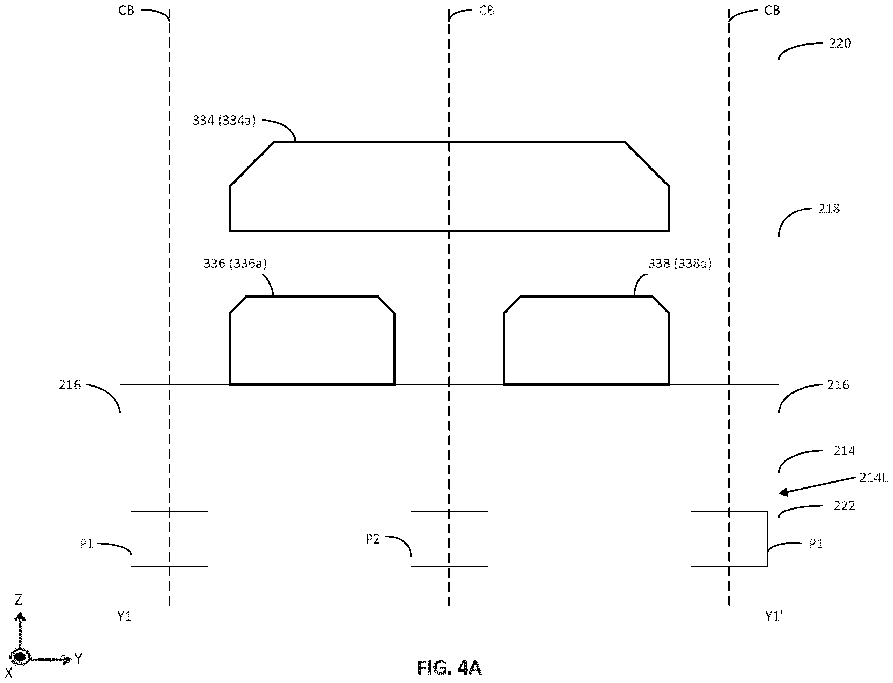

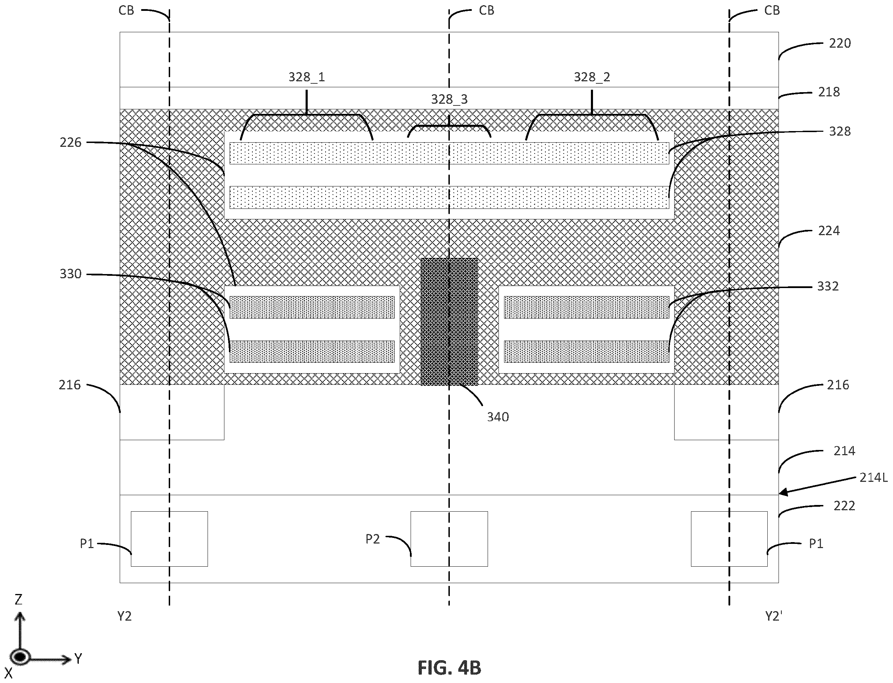

FIG. 4 is an enlarged schematic layout view of a first standard cell SC1 in FIG. 1 according to some embodiments. FIGS. 4A and 4B are cross-sectional views of the first standard cell SC1 taken along the lines Y1-Y1' and Y2-Y2' in FIG. 4, respectively, according to some embodiments. The first standard cell SC1 of FIGS. 4, 4A, and 4B may be similar to the first standard cell SC1 described with reference to FIGS. 3, 3A, and 3B, and thus repeated description of like elements will be omitted. For ease of illustration, FIG. 4 only illustrates some elements included in the first standard cell SC1.

Referring to FIGS. 4, 4A, and 4B, the first standard cell SC1 may include first and second lower channel regions 330 and 332 (also referred to as a pair of lower channel regions) and an upper channel region 328 on a portion of the substrate 214 that is between the trench isolation layers 216.

In some embodiments, each of the first and second lower channel regions 330 and 332 and the upper channel region 328 may include multiple channel regions stacked in the third direction Z, and the channel regions may be spaced apart from each other in the third direction Z. Although FIG. 4B illustrates that each of the first and second lower channel regions 330 and 332 and the upper channel region 328 includes two channel regions stacked in the third direction Z, the present disclosure is not limited thereto. In some embodiments, each of the first and second lower channel regions 330 and 332 and the upper channel region 328 may include more or less than two channel regions stacked in the third direction Z.

The first and second lower channel regions 330 and 332 and the upper channel region 328 may extend through the gate electrode 224 in the first direction X, and the gate insulator may be provided between the gate electrode 224 and each of the first and second lower channel regions 330 and 332 and the upper channel region 328 to provide insulation therebetween. The gate insulator may contact the gate electrode 224 and/or each of the first and second lower channel regions 330 and 332 and the upper channel region 328. The gate insulator may separate the gate electrode 224 from the first and second lower channel regions 330 and 332 and the upper channel region 328. Although not illustrated in FIG. 4, the gate electrode 224 may extend longitudinally in the second direction Y to intersect the first and second lower channel regions 330 and 332 and the upper channel region 328.

The first standard cell SC1 may include a first pair of lower source/drain regions 336 (e.g., first and second lower source/drain regions 336a and 336b), a second pair of lower source/drain regions 338 (e.g., third and fourth lower source/drain regions 338a and 338b), and a pair of upper source/drain regions 334 (e.g., first and second upper source/drain regions 334a and 334b). Although not illustrated in FIG. 4, the gate electrode 224 may be provided between the first pair of lower source/drain regions 336 in the first direction X, between the second pair of lower source/drain regions 338 in the first direction X, and between the pair of upper source/drain regions 334 in the first direction X. The pair of upper source/drain regions 334 may contact opposing side surfaces of the upper channel region 328 in the first direction X, respectively, as illustrated in FIG. 4. Similarly, the first pair of lower source/drain regions 336 may contact opposing side surfaces of the first lower channel region 330 in the first direction X, respectively, and the second pair of lower source/drain regions 338 may contact opposing side surfaces of the second lower channel region 332 in the first direction X, respectively.

Each of the first and second lower channel regions 330 and 332 and the upper channel region 328 may include semiconductor material(s) (e.g., Si, Ge, SiGe, GaP, GaAs, SiC, SiGeC and/or InP). In some embodiments, each of the first and second lower channel regions 330 and 332 and the upper channel region 328 may be a nanosheet that may have a thickness in a range of 1 nm to 100 nm in the third direction Z or may be a nanowire that may have a circular cross-section with a diameter in a range of 1 nm to 100 nm.

Although not illustrated, in some embodiments, one or more of the first and second lower channel regions 330 and 332 and the upper channel region 328 may be shaped like a fin. When the first lower channel region 330, the second lower channel region 332, and/or the upper channel region 328 are nanosheets or nanowires, the gate electrode 224 may surround the first lower channel region 330, the second lower channel region 332, and/or the upper channel region 328 on four sides thereof. When the first lower channel region 330, the second lower channel region 332, and/or the upper channel region 328 have a fin shape, the gate electrode 224 may surround the first lower channel region 330, the second lower channel region 332, and/or the upper channel region 328 on two, three, or four sides thereof.

Each of the first pair of lower source/drain regions 336, the second pair of lower source/drain regions 338, and the pair of upper source/drain regions 334 may include a semiconductor layer (e.g., a silicon (Si) layer and/or a silicon germanium (SiGe) layer) and may additionally include dopants in the semiconductor layer. In some embodiments, each of the first pair of lower source/drain regions 336, the second pair of lower source/drain regions 338, and the pair of upper source/drain regions 334 may include a metallic layer that includes, for example, tungsten (W), aluminum (Al), copper (Cu), molybdenum (Mo), cobalt (Co) and/or ruthenium (Ru).

A first lower transistor may include the first lower channel region 330, the first pair of lower source/drain regions 336, and a portion of the gate electrode 224. A second lower transistor may include the second lower channel region 332, the second pair of lower source/drain regions 338, and a portion of the gate electrode 224. An upper transistor may include the upper channel region 328, the pair of upper source/drain regions 334, and a portion of the gate electrode 224.

In some embodiments, the first and second lower transistors may be PMOSFETs, and the upper transistor may be an NMOSFET, or vice versa, depending on the specifications of the first standard cell SC1. Together, the first and second lower transistors and the upper transistor may constitute a stacked FET.

In some embodiments, the gate electrode 224 may be a common gate layer, as illustrated in FIG. 4B. A first portion of the gate electrode 224 may be a first gate electrode of the upper transistor including the upper channel region 328, a second portion of the gate electrode 224 may be a second gate electrode of the first lower transistor including the first lower channel region 330, and a third portion of the gate electrode 224 may be a third gate electrode of the second lower transistor including the second lower channel region 332. As the gate electrode 224 is shared by the first and second lower transistors and the upper transistor, an input of the first standard cell SC1 may be applied in common through the gate electrode 224. Although FIG. 4B illustrates that the gate electrode 224 is shared by the first and second lower transistors and the upper transistor, the present disclosure is not limited thereto. In some embodiments, a lower portion of the gate electrode 224 may be separated from and spaced apart from an upper portion of the gate electrode 224. For example, insulating layer(s) may be between the lower and upper portions of the gate electrode 224 and may separate the lower portion of the gate electrode 224 from the upper portion of the gate electrode 224. In this case, the lower portion of the gate electrode 224 may be a first gate electrode of the first and second lower transistors, and the upper portion of the gate electrode 224 may be a second gate electrode of the upper transistor.

In some embodiments, each of the first and second lower transistors and the upper transistor may be a 3D-FET such as a MBCFET. In some embodiments, one or more of the first and second lower transistors and the upper transistor may have a structure different from that illustrated. For example, one or more of the first and second lower transistors and the upper transistor may be a GAAFET including a single channel region or a FinFET.

The first and second lower transistors and the upper transistor may be provided in the interlayer insulating layer 218. In particular, the first and second lower channel regions 330 and 332, the upper channel region 328, the first pair of lower source/drain regions 336, the second pair of lower source/drain regions 338, the pair of upper source/drain regions 334, and the gate electrode 224 may be provided in the interlayer insulating layer 218.

The first and second power lines P1 and P2 may each be electrically connected to a power source with a predetermined voltage (e.g., a drain voltage V_{DD} or a source voltage Vss), which is used to power the first pair of lower source/drain regions 336, the second pair of lower source/drain regions 338, and/or the pair of upper source/drain regions 334. For example, the first and second power lines P1 and P2 may be electrically connected to the first pair of lower source/drain regions 336, the second pair of lower source/drain regions 338, and/or the pair of upper source/drain regions 334 through conductive via(s) and/or contact structure(s).

An insulating layer 340 may extend between the first lower channel region 330 and the second lower channel region 332. The insulating layer 340 may separate the first lower channel region 330 from the second lower channel region 332 in the second direction Y. For example, the insulating layer 340 may include insulating material(s) (e.g., silicon oxide, silicon oxynitride, silicon nitride, silicon carbonitride, silicon boron nitride and/or a low-k material). Although the insulating layer 340 is illustrated as a single layer, in some embodiments, the insulating layer 340 may include multiple layers.

The upper channel region 328 may be formed such that it extends longitudinally in the second direction Y and overlaps the second power line P2 in the third direction Z. In other words, the second power line P2 and the cell boundary CB defined by the second power line P2 may overlap the upper channel region 328 in the third direction Z. For example, the upper channel region 328 may include a central portion in the second direction Y (e.g., a third portion 328_3) that overlaps the second power line P2 in the third direction Z.

The upper channel region 328 may be electrically connected to the pair of upper source/drain regions 334 on opposing sides thereof in the first direction X, respectively. The pair of upper source/drain regions 334 may extend longitudinally in the second direction Y and overlap the second power line P2 in the third direction Z. For example, each of the pair of upper source/drain regions 334 may include a central portion in the second direction Y that overlaps the second power line P2 in the third direction Z.

The upper channel region 328 may be on the first and second lower channel regions 330 and 332. The first and second lower channel regions 330 and 332 may be between the substrate 214 and the upper channel region 328. The first and second lower channel regions 330 and 332 may not be merged or formed as a single unit, and may not overlap the second power line P2 in the third direction Z. That is, the first and second lower channel regions 330 and 332 may be free of overlap with the second power line P2 and the cell boundary CB defined by the second power line P2 in the third direction Z.

The first lower channel region 330 may be electrically connected to the first pair of lower source/drain regions 336 on opposing sides thereof in the first direction X, respectively. The second lower channel region 332 may be electrically connected to the second pair of lower source/drain regions 338 on opposing sides thereof in the first direction X, respectively. The first pair of lower source/drain regions 336 and the second pair of lower source/drain regions 338 may be free of overlap with the second power line P2 and the cell boundary CB defined by the second power line P2 in the third direction Z.

A width of the upper channel region 328 in the second direction Y may be greater than a width of the first lower channel region 330 in the second direction Y. Similarly, the width of the upper channel region 328 in the second direction Y may be greater than a width of the second lower channel region 332 in the second direction Y. For example, the width of the upper channel region 328 in the second direction Y may be at least 1.5 times greater (i.e., at least 1.5 times wider) than the width of each of the first and second lower channel regions 330 and 332 in the second direction Y. In some embodiments, the width of the upper channel region 328 in the second direction Y may be at least 2 times greater (i.e., at least 2 times wider) than the width of each of the first and second lower channel regions 330 and 332 in the second direction Y. In some embodiments, the width of the upper channel region 328 in the second direction Y may be greater than a combined width of the first and second lower channel regions 330 and 332 in the second direction Y.

Respective widths of the pair of upper source/drain regions 334 in the second direction Y may be greater than respective widths of the first pair of lower source/drain regions 336 in the second direction Y. Similarly, the respective widths of the pair of upper source/drain regions 334 in the second direction Y may be greater than respective widths of the second pair of lower source/drain regions 338 in the second direction Y. For example, the respective widths of the pair of upper source/drain regions 334 in the second direction Y may be at least 1.5 times greater (i.e., at least 1.5 times wider) than the respective widths of the first pair of lower source/drain regions 336 in the second direction Y. Similarly, the respective widths of the pair of upper source/drain regions 334 in the second direction Y may be at least 1.5 times greater (i.e., at least 1.5 times wider) than the respective widths of the second pair of lower source/drain regions 338 in the second direction Y. In some embodiments, the respective widths of the pair of upper source/drain regions 334 in the second direction Y may be at least 2 times greater (i.e., at least 2 times wider) than the respective widths of the first pair of lower source/drain regions 336 in the second direction Y. Similarly, the respective widths of the pair of upper source/drain regions 334 in the second direction Y may be at least 2 times greater (i.e., at least 2 times wider) than the respective widths of the second pair of lower source/drain regions 338 in the second direction Y.

In some embodiments, the width of the first upper source/drain region 334a in the second direction Y may be greater than a combined width of the first and third lower source/drain regions 336a and 338a in the second direction Y and may also be greater than a combined width of the second and fourth lower source/drain regions 336b and 338b in the second direction Y. Similarly, the width of the second upper source/drain region 334b in the second direction Y may be greater than the combined width of the first and third lower source/drain regions 336a and 338a in the second direction Y and may also be greater than the combined width of the second and fourth lower source/drain regions 336b and 338b in the second direction Y.

The upper channel region 328 may overlap the first and second lower channel regions 330 and 332 in the third direction Z. The first upper source/drain region 334a may overlap the first and third lower source/drain regions 336a and 338a in the third direction Z. The second upper source/drain region 334b may overlap the second and fourth lower source/drain regions 336b and 338b in the third direction Z.

The upper channel region 328 may include a first portion 328_1, a second portion 328_2, and a third portion 328_3 (see FIG. 4B). The first and second portions 328_1 and 328_2 of the upper channel region 328 may be free of overlap with the second power line P2 in the third direction Z. The third portion 328_3 of the upper channel region 328 may be between the first and second portions 328_1 and 328_2 and may overlap the second power line P2 in the third direction Z. For example, the first portion 328_1 of the upper channel region 328 may be on the first lower channel region 330, and the second portion 328_2 of the upper channel region 328 may be on the second lower channel region 332. The third portion 328_3 of the upper channel region 328 may be a central portion of the upper channel region 328 in the second direction Y. The first portion 328_1 of the upper channel region 328 may overlap the first lower channel region 330 in the third direction Z, and the second portion 328_2 of the upper channel region 328 may overlap the second lower channel region 332 in the third direction Z. The third portion 328_3 of the upper channel region 328 may be free of overlap with the first and second lower channel regions 330 and 332 in the third direction Z.

The first standard cell SC1 is a double height cell and thus the upper channel region 328 and the first and second lower channel regions 330 and 332 may be free of overlap with the first power lines P1 in the third direction Z. The upper channel region 328 may include a central portion in the second direction Y (e.g., the third portion 328_3) that is spaced apart from each of the first power lines P1 in the second direction Y by an equal distance. The first lower channel region 330 may include a central portion in the second direction Y that is spaced apart from one of the first power lines P1 and the second power line P2 in the second direction Y by an equal distance. The second lower channel region 332 may include a central portion in the second direction Y that is spaced apart from the other one of the first power lines P1 and the second power line P2 in the second direction Y by an equal distance.

The upper transistor of the stacked FET may include the upper channel region 328 that is merged, or singular, such that it extends longitudinally in the second direction Y and overlaps the second power line P2 in the third direction Z. Accordingly, an effective channel width of the upper transistor in the second direction Y may be increased, thereby improving the performance of the integrated circuit device. Further, the first standard cell SC1 may have improved timing synchronization because of the increased effective channel width of the upper transistor.

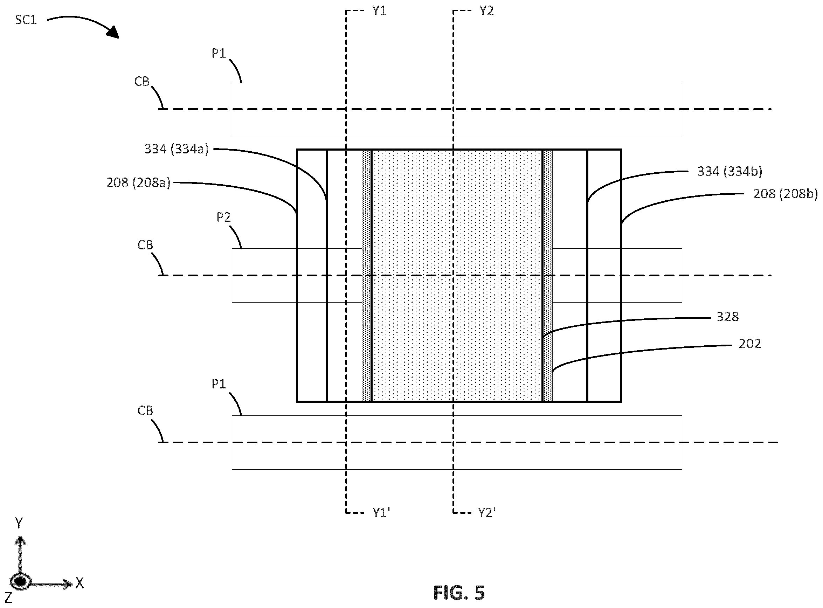

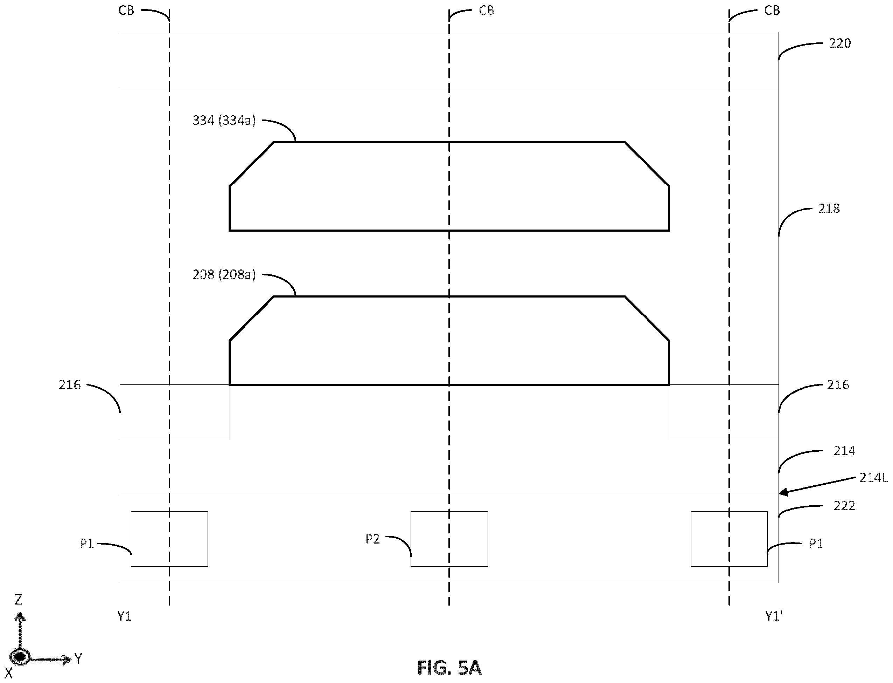

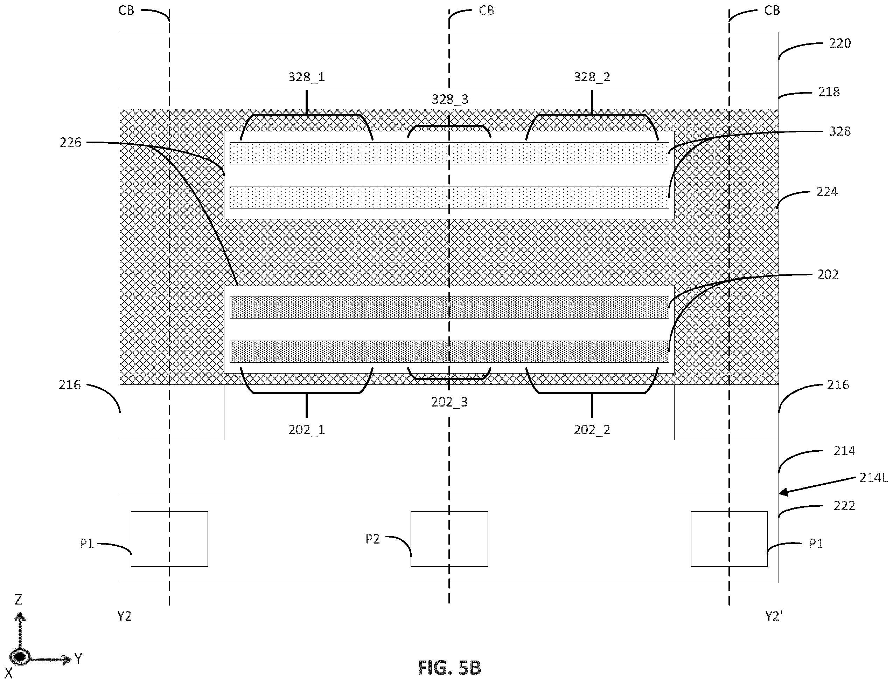

FIG. 5 is an enlarged schematic layout view of a first standard cell SC1 in FIG. 1 according to some embodiments. FIGS. 5A and 5B are cross-sectional views of the first standard cell SC1 taken along the lines Y1-Y1' and Y2-Y2' in FIG. 5, respectively, according to some embodiments. The first standard cell SC1 of FIGS. 5, 5A, and 5B may be similar to the first standard cell SC1 described with reference to FIGS. 3, 3A, 3B, 4, 4A, and 4B and thus repeated description of like elements will be omitted. For ease of illustration, FIG. 5 only illustrates some elements included in the first standard cell SC1.

Referring to FIGS. 5, 5A, and 5B, the first standard cell SC1 may include the lower channel region 202 and the pair of lower source/drain regions 208 described with reference to FIGS. 3, 3A, and 3B. The first standard cell SC1 may also include the upper channel region 328 and the pair of upper source/drain regions 334 described with reference to FIGS. 4, 4A, and 4B.

The lower and upper channel regions 202 and 328 may be on a portion of the substrate 214 that is between the trench isolation layers 216. A lower transistor may include the lower channel region 202, the pair of lower source/drain regions 208, and a portion of the gate electrode 224. An upper transistor may include the upper channel region 328, the pair of upper source/drain regions 334, and a portion of the gate electrode 224.

In some embodiments, the lower transistor may be a PMOSFET, and the upper transistor may be an NMOSFET, or vice versa, depending on the specifications of the first standard cell SC1. Together, the lower transistor and the upper transistor may constitute a stacked FET. In some embodiments, each of the lower transistor and the upper transistor may be a 3D-FET such as a MBCFET. In some embodiments, one or more of the lower transistor and the upper transistor may have a structure different from that illustrated. For example, one or more of the lower transistor and the upper transistor may be a GAAFET including a single channel region or a FinFET.

The lower and upper channel regions 202 and 328 may both be formed such that they extend longitudinally in the second direction Y and overlap the second power line P2 in the third direction Z. In other words, the second power line P2 and the cell boundary CB defined by the second power line P2 may overlap both the lower and upper channel regions 202 and 328 in the third direction Z. For example, each of the lower and upper channel regions 202 and 328 may include a central portion in the second direction Y (e.g., a third portion 202_3 and a third portion 328_3, respectively) that overlaps the second power line P2 in the third direction Z.

The lower channel region 202 may be electrically connected to the pair of lower source/drain regions 208 on opposing sides thereof in the first direction X, respectively. The pair of lower source/drain regions 208 may extend longitudinally in the second direction Y and overlap the second power line P2 in the third direction Z. For example, each of the pair of lower source/drain regions 208 may include a central portion in the second direction Y that overlaps the second power line P2 in the third direction Z.

The upper channel region 328 may be electrically connected to the pair of upper source/drain regions 334 on opposing sides thereof in the first direction X, respectively. The pair of upper source/drain regions 334 may extend longitudinally in the second direction Y and overlap the second power line P2 in the third direction Z. For example, each of the pair of upper source/drain regions 334 may include a central portion in the second direction Y that overlaps the second power line P2 in the third direction Z.

The lower channel region 202 may be between the substrate 214 and the upper channel region 328. The lower and upper channel regions 202 and 328 may overlap each other in the third direction Z. Similarly, the pair of lower and upper source/drain regions 208 and 334 may overlap each other in the third direction Z. That is, the first lower source/drain region 208a may overlap the first upper source/drain region 334a in the third direction Z, and the second lower source/drain region 208b may overlap the second upper source/drain region 334b in the third direction Z.

The lower channel region 202 may include the first, second, and third portions 202_1, 202_2, and 202_3 (see FIG. 5B). The first and second portions 202_1 and 202_2 of the lower channel region 202 may be free of overlap with the second power line P2 in the third direction Z. The third portion 202_3 of the lower channel region 202 may be between the first and second portions 202_1 and 202_2 thereof and may overlap the second power line P2 in the third direction Z. The third portion 202_3 of the lower channel region 202 may be a central portion of the lower channel region 202 in the second direction Y. Each of the first, second, and third portions 202_1, 202_2, and 202_3 of the lower channel region 202 may overlap the upper channel region 328 in the third direction Z.

The upper channel region 328 may include the first, second, and third portions 328_1, 328_2, and 328_3 (see FIG. 5B). The first and second portions 328_1 and 328_2 of the upper channel region 328 may be free of overlap with the second power line P2 in the third direction Z. The third portion 328_3 of the upper channel region 328 may be between the first and second portions 328_1 and 328_2 thereof and may overlap the second power line P2 in the third direction Z. The third portion 328_3 of the upper channel region 328 may be a central portion of the upper channel region 328 in the second direction Y. Each of the first, second, and third portions 328_1, 328_2, and 328_3 of the upper channel region 328 may overlap the lower channel region 202 in the third direction Z.

The first standard cell SC1 is a double height cell and thus the lower and upper channel regions 202 and 328 may be free of overlap with the first power lines P1 in the third direction Z. The lower channel region 202 may include a central portion in the second direction Y (e.g., the third portion 202_3) that is spaced apart from each of the first power lines P1 in the second direction Y by an equal distance. Similarly, the upper channel region 328 may include a central portion in the second direction Y (e.g., the third portion 328_3) that is spaced apart from each of the first power lines P1 in the second direction Y by an equal distance.

The lower transistor of the stacked FET may include the lower channel region 202 that is merged, or singular, such that it extends longitudinally in the second direction Y and overlaps the second power line P2 in the third direction Z. Likewise, the upper transistor of the stacked FET may include the upper channel region 328 that is merged, or singular, such that it extends longitudinally in the second direction Y and overlaps the second power line P2 in the third direction Z Accordingly, an effective channel width of the lower transistor and the upper transistor in the second direction Y may be increased, thereby improving the performance of the integrated circuit device. Further, the first standard cell SC1 may have improved timing synchronization because of the increased effective channel width of the lower transistor and the upper transistor.

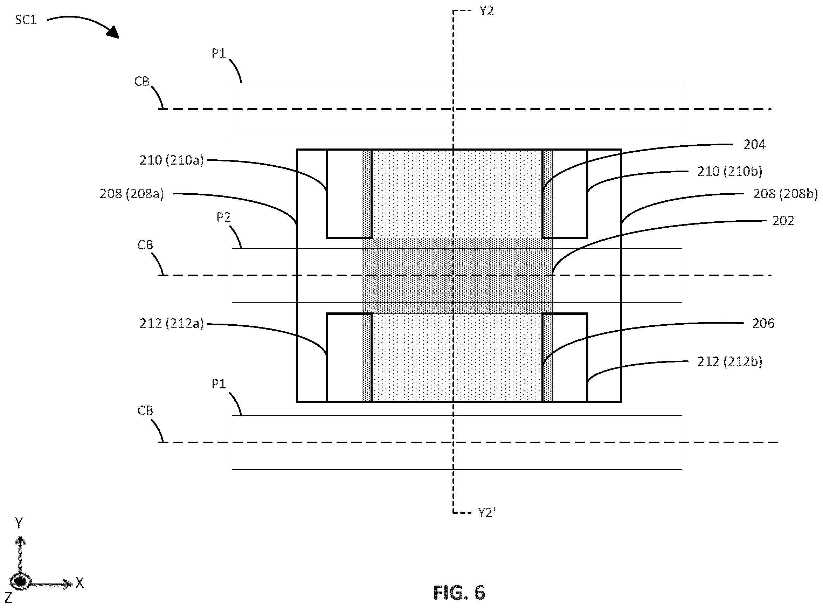

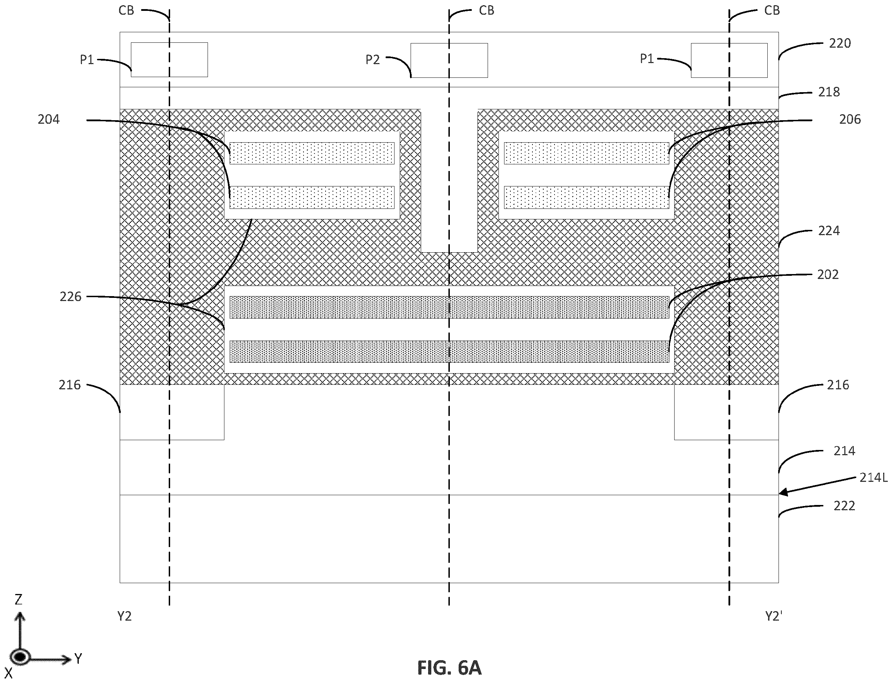

FIG. 6 is an enlarged schematic layout view of a first standard cell SC1 in FIG. 1 according to some embodiments. FIG. 6A is a cross-sectional view of the first standard cell SC1 taken along the line Y2-Y2' in FIG. 6 according to some embodiments. The first standard cell SC1 of FIGS. 6 and 6A may be similar to the first standard cell SC1 described with reference to FIGS. 3, 3A, 3B, 4, 4A, 4B, 5, 5A, and 5B and thus repeated description of like elements will be omitted. For ease of illustration, FIG. 6 only illustrates some elements included in the first standard cell SC1.

Referring to FIGS. 6 and 6A, the standard cell SC1 may include the lower channel region 202, the first and second upper channel regions 204 and 206, the pair of lower source/drain regions 208, the first pair of upper source/drain regions 210, and the second pair of upper source/drain regions 212 described with reference to FIGS. 3, 3A, and 3B.

The first standard cell SC1 may include the first and second power lines P1 and P2. The first and second power lines P1 and P2 may be included in the BEOL structure 220 that is formed through the BEOL portion of device fabrication. The first and second power lines P1 and P2 may be on the interlayer insulating layer 218. The first and second power lines P1 and P2 may each be electrically connected to a power source with a predetermined voltage (e.g., a drain voltage V_{DD} or a source voltage Vss), which is used to power the pair of lower source/drain regions 208, the first pair of upper source/drain regions 210, and/or the second pair of upper source/drain regions 212. For example, the first and second power lines P1 and P2 may be electrically connected to the pair of lower source/drain regions 208, the first pair of upper source/drain regions 210, and/or the second pair of upper source/drain regions 212 through conductive via(s) and/or contact structure(s).

Although not illustrated in FIGS. 6 and 6A, in some embodiments, one or more of the first and second power lines P1 and P2 may be included in the BEOL structure 220, and one or more of the first and second power lines P1 and P2 may be included in the BSPDNS 222. That is, the first and second power lines P1 and P2 may be included in the BEOL structure 220 and/or the BSPDNS 222.

While FIGS. 6 and 6A are similar to the first standard cell SC1 described with reference to FIGS. 3, 3A, and 3B, it will be understood that one or more of the first and second power lines P1 and P2 may also be included in the BEOL structure 220 in the first standard cell SC1 described with reference to FIGS. 4, 4A, 4B, 5, 5A, and 5B.

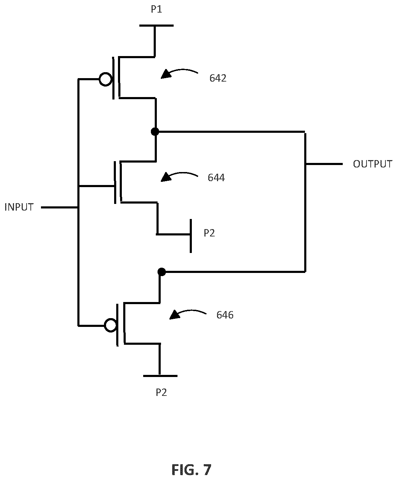

FIG. 7 is a circuit diagram of an example logic circuit included in a first standard cell SC1 in FIG. 1 according to some embodiments.

Referring to FIG. 7, a logic circuit may be designed to be a double height cell and may be included in the first standard cell SC1 in FIG. 1. The logic circuit may include two P-type transistors 642 and 646 and a single N-type transistor 644. In some embodiments, the N-type transistor 644 may have a size bigger than that of each of the two P-type transistors 642 and 646. For example, the N-type transistor 644 may include a channel region having a width that is greater than that of that of each of the two P-type transistors 642 and 646. For example, the logic circuit may correspond to the first standard cell SC 1 described with reference to FIGS. 3, 3A, and 3B or the first standard cell SC1 described with reference to FIGS. 4, 4A, and 4B.

The first power line P1 may supply a first voltage (e.g., a drain voltage V_{DD}) to the P-type transistors 642 and 646 and the N-type transistor 644. The second power line P2 may supply a second voltage (e.g., a source voltage Vss) to the P-type transistors 642 and 646 and the N-type transistor 644.

Although FIGS. 2, 3, 3A, 3B, 4, 4A, 4B, 5, 5A, 5B, 6, 6A, and 7 illustrate a first standard cell SC1 that is a double height standard cell, it will be understood that the present disclosure is also applicable to other multi-height standard cells (e.g., a triple height standard cell or a quadruple height standard cell).

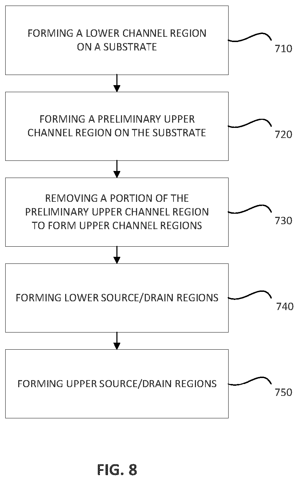

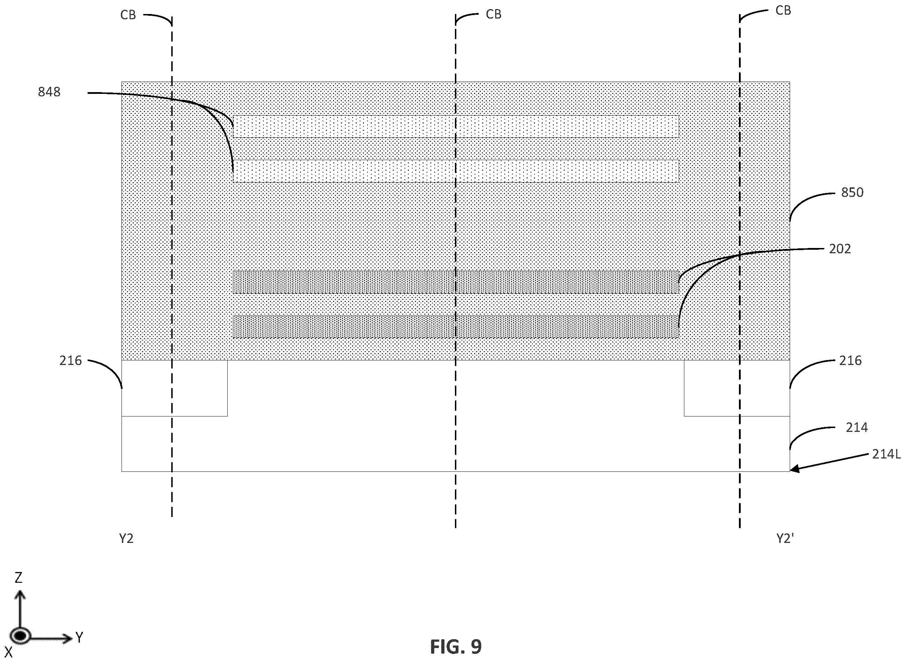

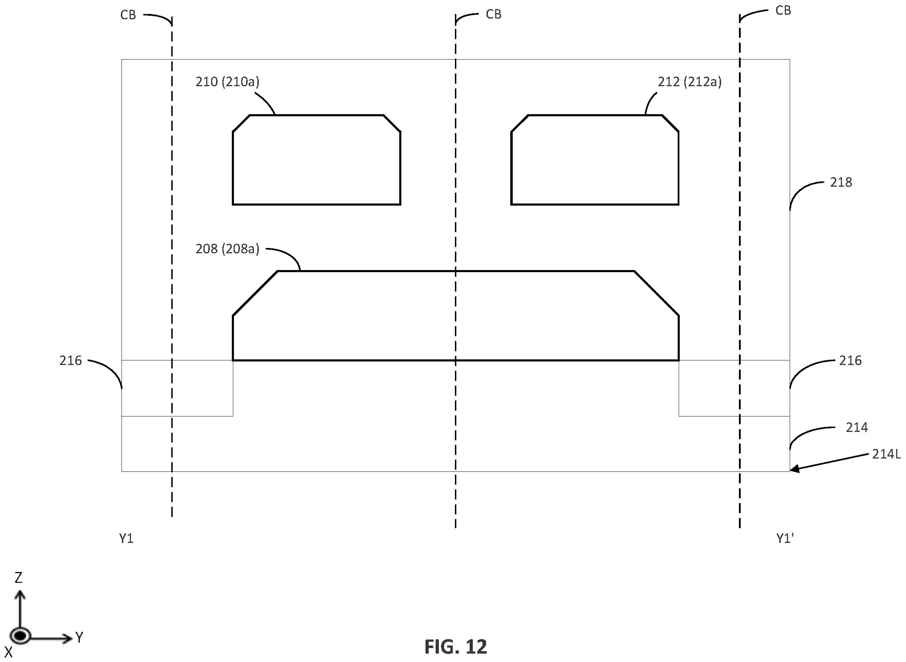

FIG. 8 is a flow chart of methods of forming an integrated circuit device according to some embodiments. FIGS. 9 through 12 are cross-sectional views illustrating the methods of forming an integrated circuit device according to some embodiments. In particular, FIGS. 9 through 11 are cross-sectional views corresponding to the line Y2-Y2' of FIG. 3, and FIG. 12 is a cross-sectional view corresponding to the line Y1-Y1' of FIG. 3.

Referring to FIGS. 8 and 9, the lower channel region 202 may be formed on the substrate 214 (BLOCK 710). The lower channel region 202 may be alternately stacked in the third direction Z with portions of a sacrificial layer 850. A preliminary upper channel region 848 may be formed on the substrate 214 (BLOCK 720). The lower channel region 202 may be between the substrate 214 and the preliminary upper channel region 848. The preliminary upper channel region 848 may be alternately stacked in the third direction Z with portions of the sacrificial layer 850. Although the sacrificial layer 850 is illustrated as a single layer, in some embodiments, the sacrificial layer 850 may include multiple layers that are alternately stacked with the lower channel region 202 and the preliminary upper channel region 848. The lower channel region 202 and the preliminary upper channel region 848 may be on a portion of the substrate 214 that is between the trench isolation layers 216.

The sacrificial layer 850 may include a material having an etch selectivity with respect to the lower channel region 202 and the preliminary upper channel region 848. The sacrificial layer 850 may include, for example, semiconductor material(s) (e.g., Si, Ge, SiGe, GaP, GaAs, SiC, SiGeC and/or InP). In some embodiments, the sacrificial layer 850 may include a SiGe layer.

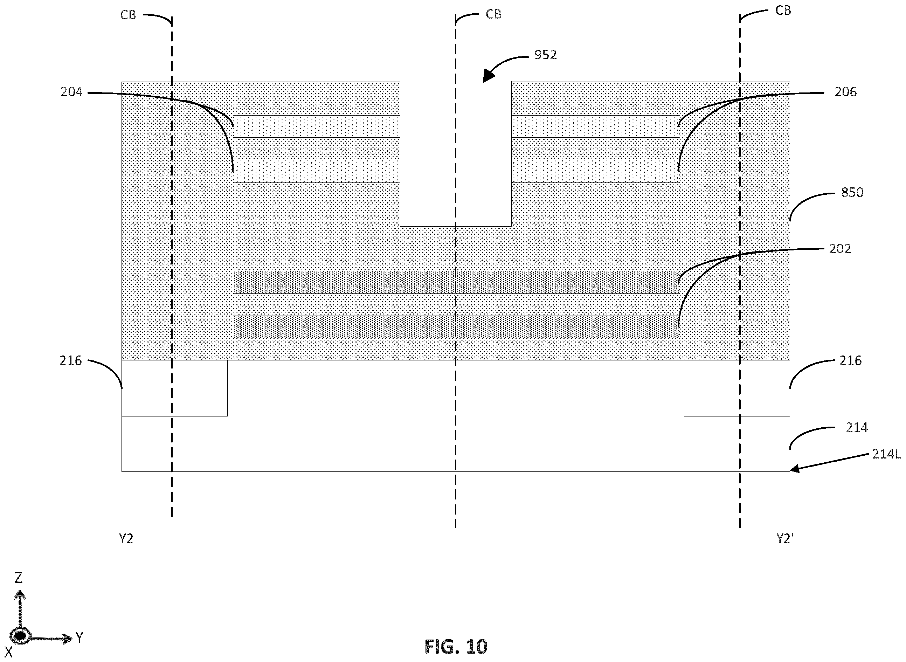

Referring to FIGS. 8 and 10, a portion of the preliminary upper channel region 848 may be removed to form the first and second upper channel regions 204 and 206. (BLOCK 730). For example, a central portion of the preliminary upper channel region 848 in the second direction Y may be removed, thereby forming the first and second upper channel regions 204 and 206. The portion of the preliminary upper channel region 848 may be removed, for example, by an etching process (e.g., a dry etching process and/or a wet etching process). A recess 952 may be formed in the sacrificial layer 850 as a result of removing the portion of the preliminary upper channel region 848. Portions of the sacrificial layer 850 may also be removed when removing the portion of the preliminary upper channel region 848.

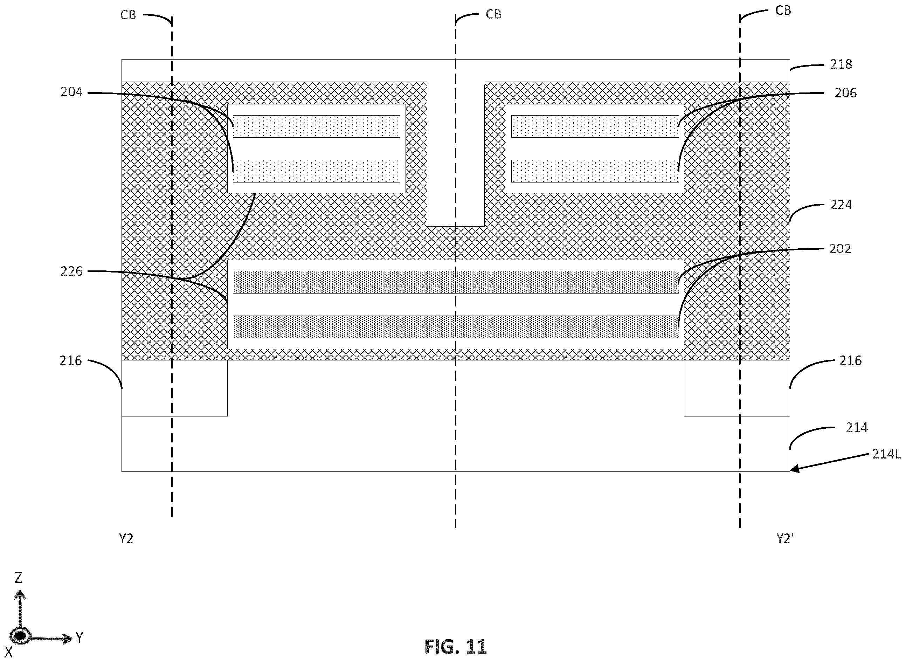

Referring to FIG. 11, the sacrificial layer 850 may be removed and replaced with the gate electrode 224 and the gate insulator. For example, the sacrificial layer 850 may have an etch selectivity with respect to the lower channel region 202 and the first and second upper channel regions 204 and 206 and may thus be selectively removed by an etching process (e.g., a dry etching process and/or wet etching process) without removing the lower channel region 202 and the first and second upper channel regions 204 and 206.

The work function layer(s) 226 may be provided between the gate electrode 224 and the gate insulator. In some embodiments, the work function layer(s) 226 may extend between the gate electrode 224 and the gate insulator and may separate the gate electrode 224 from the gate insulator.

The interlayer insulating layer 218 may be formed on the gate electrode 224 and may extend between the first upper channel region 204 and the second upper channel region 206. The interlayer insulating layer 218 may separate the first upper channel region 204 from the second upper channel region 206 in the second direction Y.

Referring to FIGS. 8 and 12, the pair of lower source/drain regions 208 may be formed (BLOCK 740). The pair of lower source/drain regions 208 may be formed by performing an epitaxial growth process using the lower channel region 202 as a seed layer. Specifically, the pair of lower source/drain regions 208 may be grown from opposing side surfaces of the lower channel region 202 in the first direction X, respectively, through the epitaxial growth process. The first lower source/drain region 208a may be grown from a first side surface of the lower channel region 202, and the second lower source/drain region 208b (see FIG. 3) may be grown from a second side surface of the lower channel region 202 that opposes the first side surface in the first direction X.

The first pair of upper source/drain regions 210 and the second pair of upper source/drain regions 212 may be formed (BLOCK 750). The first pair of upper source/drain regions 210 may be formed by performing an epitaxial growth process using the first upper channel region 204 as a seed layer. Specifically, the first pair of upper source/drain regions 210 may be grown from opposing side surfaces of the first upper channel region 204 in the first direction X, respectively, through the epitaxial growth process. The first upper source/drain region 210a may be grown from a first side surface of the first upper channel region 204, and the second upper source/drain region 210b (see FIG. 3) may be grown from a second side surface of the first upper channel region 204 that opposes the first side surface in the first direction X. The second pair of upper source/drain regions 212 may be formed by performing an epitaxial growth process using the second upper channel region 206 as a seed layer. Specifically, the second pair of upper source/drain regions 212 may be grown from opposing side surfaces of the second upper channel region 206 in the first direction X, respectively, through the epitaxial growth process. The third upper source/drain region 212a may be grown from a first side surface of the second upper channel region 206, and the fourth upper source/drain region 212b (see FIG. 3) may be grown from a second side surface of the second upper channel region 206 that opposes the first side surface in the first direction X.

Referring back to FIGS. 3, 3A, and 3B, the BEOL structure 220 may be formed through the BEOL portion of device fabrication. The BSPDNS 222 including the first and second power lines P1 and P2 may also be formed. Central portions of each of the first and second power lines P1 and P2 in the second direction Y may define cell boundaries CB.

It will be understood that the standard cell SC1 included in the integrated circuit device 100 described with reference to FIGS. 4, 4A, 4B, 5, 5A, 5B, 6, and 6A can be formed by methods similar to those described with reference to FIGS. 8 through 12 with appropriate modification thereto.

For example, in the first standard cell SC1 described with reference to FIGS. 4, 4A, and 4B, a portion of a preliminary lower channel region may be removed to form the first and second lower channel regions 330 and 332. The insulating layer 340 may fill a recess that results from removing the portion of the preliminary lower channel region. The insulating layer 340 may extend between the first lower channel region 330 and the second lower channel region 332 and may separate the first lower channel region 330 from the second lower channel region 332 in the second direction Y.

For example, in the first standard cell SC1 described with reference to FIGS. 5, 5A, and 5B, portions of the lower channel region 202 and the upper channel region 328 may not be removed so that the lower and upper channel regions 202 and 328 may both be merged to extend longitudinally in the second direction Y and overlap the second power line P2 in the third direction Z.

For example, in the first standard cell SC1 described with reference to FIGS. 6 and 6A, the power lines P1 and P2 may be formed through the BEOL portion of device fabrication in the BEOL structure 220 rather than during formation of the BSPDNS 222.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing. Although an element is illustrated as a single layer in the drawings, that element may include multiple layers.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "connected" or "on" another element, it can be directly connected or on the other element, or intervening elements may also be present. In contrast, when an element is referred to as being "directly connected" or "directly on" another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. An integrated circuit device comprising:
an upper transistor comprising an upper channel region (204, 328) on a substrate (214);
a lower transistor between the substrate (214) and the upper transistor, the lower transistor comprising a lower channel region (202, 330); and
a power line (P2) extending longitudinally in a first horizontal direction (X),
wherein at least one (202, 328) of the upper channel region (204, 328) or the lower channel region (202, 330) extends longitudinally in a second horizontal direction (Y) that traverses the first horizontal direction (X), and
the at least one (202, 328) of the upper channel region (204, 328) or the lower channel region (202, 330) overlaps the power line (P1) in a thickness direction (Z).

2. The integrated circuit device of Claim 1, wherein the at least one (202, 328) of the upper channel region (204, 328) or the lower channel region (202, 330) is electrically connected to a source/drain region (208, 334) that overlaps the power line (P2) in the thickness direction (Z).

3. The integrated circuit device of Claim 1 or 2, wherein the at least one (202, 328) of the upper channel region (204, 328) or the lower channel region (202, 330) comprises a central portion (202_3, 328_3) in the second horizontal direction (Y) that overlaps the power line (P2) in the thickness direction (Z).

4. The integrated circuit device of any one of Claims 1 to 3, wherein the lower channel region (202) overlaps the power line (P2) in the thickness direction (Z), and the upper channel region (204) is free of overlap with the power line (P2) in the thickness direction (Z).

5. The integrated circuit device of Claim 4, wherein a width of the lower channel region (202) in the second horizontal direction (Y) is at least two times wider than a width of the upper channel region (204) in the second horizontal direction (Y).

6. The integrated circuit device of Claim 4 or 5, wherein the upper transistor is a first upper transistor, and the upper channel region (204) is a first upper channel region,
the integrated circuit device further comprises a second upper transistor comprising a second upper channel region (206) that is spaced apart from the first upper channel region (204) in the second horizontal direction (Y), and
the lower channel region (202) overlaps the first and second upper channel regions (204, 206) in the thickness direction (Z).

7. The integrated circuit device of any one of Claims 1 to 3, wherein the upper channel region (328) overlaps the power line (P2) in the thickness direction (Z), and the lower channel region (330) is free of overlap with the power line (P2)in the thickness direction (Z).

8. The integrated circuit device of Claim 7, wherein a width of the upper channel region (328) in the second horizontal direction (Y) is at least two times wider than a width of the lower channel region (330) in the second horizontal direction (Y).

9. The integrated circuit device of any one of Claims 1 to 3, wherein both the upper channel region (328) and the lower channel region (202) overlap the power line (P2) in the thickness direction (Z).

10. The integrated circuit device of any one of Claims 1to 9, wherein the power line (P2) is a first power line,
the integrated circuit device further comprises a second power line (P1) and a third power line (P1) that are spaced apart from each other in the second horizontal direction (Y) with the first power line (P2) therebetween, and
the at least one (202, 328) of the upper channel region (204, 328) or the lower channel region (202, 330) comprises a portion that is spaced apart from the second and third power lines (P1) in the second horizontal direction (Y) by an equal distance.

11. An integrated circuit device comprising:
a first transistor comprising a first channel region (202; 328) on a substrate (214); and
a pair of second transistors, respectively, comprising a pair of second channel regions (204, 206; 330, 332) that are spaced apart from each other in a first horizontal direction (Y),
wherein the first channel region (202; 328) overlaps the pair of second channel regions (204, 206; 330, 332) in a thickness direction (Z).

12. The integrated circuit device of Claim 11, wherein the first channel region (202) is between the substrate (214) and the pair of second channel regions (204, 206).

13. The integrated circuit device of Claim 11, wherein the pair of second channel regions (330, 332) are between the substrate (214) and the first channel region (328).

14. The integrated circuit device of any one of Claims 11 to 13, wherein the first channel region (202; 328) comprises:
a first portion (202_1; 328_1) that overlaps a first one of the pair of second channel regions (204, 206; 330, 332) in the thickness direction (Z);
a second portion (202_1; 328_1) that overlaps a second one of the pair of second channel regions (204, 206; 330, 332) in the thickness direction (Z); and
a third portion (202_3; 328_3) that is between the first (202_1; 328_1) and second portions (202_1; 328_1) and is free of overlap with the pair of second channel regions (204, 206; 330, 332) in the thickness direction (Z).

15. The integrated circuit device of any one of Claims 11 to 14, further comprising a power line (P2) extending longitudinally in a second horizontal direction (X) that traverses the first horizontal direction (Y), wherein the first channel region (202; 328) overlaps the power line (P2) in the thickness direction (Z).
